# EUROPEAN PATENT APPLICATION

(11) **EP 4 290 573 A1**
(43) Date of publication of application: **13.12.2023**
(21) Application number: 22177799.8
(22) Date of filing: 08.06.2022
(51) Int. Cl.: H01L 23/495

(54) **A SEMICONDUCTOR PACKAGE ASSEMBLY AND A METHOD OF MANUFACTURING SUCH SEMICONDUCTOR PACKAGE ASSEMBLY**

(71) Applicant: Nexperia B.V., 6534 AB Nijmegen (NL)
(72) Inventor: Yandoc, Ricardo, 22529 Hamburg (DE); Anthony, Matthew, Manchester, SK7 5BJ (GB); Zhou, Zhou, Kwaichung (HK); Brown, Adam, 22529 Hamburg (DE)
(74) Representative: Pjanovic, Ilija

(57) **Abstract**

According to the disclosure a semiconductor package (assembly) is proposed, at least comprising: a lead metallic frame; a semiconductor die structure being mounted on a die pad of the lead metallic frame; at least a first bond clip connected with the semiconductor die structure; at least a further bond clip connected with the die pad of the lead metallic frame by means of a solder junction; wherein the die pad is provided with at least one recess near the connection with the at least further bond clip for accommodating solder for the solder junction.

The disclosure also pertains to a method for manufacturing such semiconductor package (assembly).

## Description

### TECHNICAL FIELD

The present disclosure relates to a semiconductor package assembly as well as a method for manufacturing such semiconductor package assembly.

### BACKGROUND OF THE DISCLOSURE

When manufacturing a semiconductor package assembly, semiconductor components forming the semiconductor package are mounted to a lead frame and one or more bond clips are electronically connected with either the semiconductor die or with the lead frame. For finalizing the semiconductor package assembly, the semiconductor package is encapsulated using a plastic resin, thus immobilizing and protecting the fragile solder connection between the bond clips and the semiconductor die and the lead frame and allowing a proper handling and processing of the semiconductor package assembly in semiconductor applications.

However, the solder connection between the bond clips and the semiconductor die and the lead frame remains fragile in terms of durability and electrical connectivity as a too thin solder thickness still has high risk potential for product reliability. This has been proven for clip bonded packages that requires internal clip solder connections on posts or copper to copper connections using a conductive adhesive such as solder or similar. And at worst, when subjecting the bond clip connections with exposed clip devices to a temperature cycling test or an IOL test, solder degradation will occur at a faster pace or rate.

More and more semiconductor package assemblies that are commercialized require the exposed clip ends (slug ends) to be subjected to a mechanical polishing process on top of the package. This increases significantly the risk to solder damage in between the bond clip and the lead frame.

Accordingly, it is a goal of the present disclosure to provide an improved semiconductor package assembly, of which the solder connection between the bond clips and the lead frame are significantly improved.

### SUMMARY OF THE DISCLOSURE

According to a first example of the disclosure, a semiconductor package at least comprising a lead metallic frame; a semiconductor die structure being mounted on a die pad of the lead frame; at least a first bond clip connected with the semiconductor die structure; at least a further bond clip connected with the die pad of the lead frame by means of a solder junction; wherein the die pad is provided with at least one recess near the connection with the at least further bond clip for accommodating solder for the solder junction.

Herewith the solder material volume near the copper bond clip edges and/or in between a copper bond clip and the lead frame surface is significantly increased. The lead metallic frame can be chosen from any conductive metal material but preferably copper is used for the copper lead frame. Next to improved electrical connectivity also an improved mechanical connection between the bond clip and the lead frame is achieved. The connecting interface between the bond clip and the lead frame has an improved and stronger and more durable mechanical strength and is less susceptible to solder degradation due to repetitive mechanical loads or thermo-mechanical fatigue.

In beneficial examples according to the disclosure, the at least one recess has an elongated configuration, wherein the at least one elongated recess is shaped as a trench or a groove. Accordingly, the position or orientation of such elongated recesses on one side of the lead frame guarantees the accessibility for easy mounting of a bond clip connection. Particular implementations of such elongated recesses extend either in a direction parallel to a longitudinal orientation of the die pad or in a direction transverse to a longitudinal orientation of the die pad. The choice of orientation is in part dependent on the desired connecting interface between the bond clip and the lead frame and any constraints as to the dimensions of the lead frame compared to the semiconductor die structure.

In particular, the at least one elongated recess may have a V-shaped depth profile, thus ensuring an effective reservoir for solder material as well as an increased mechanical strength along the connecting interface of solder junction between the bond clip and the lead frame once the solder junction has been established. In a preferred example wherein the resulting solder interface has a high mechanical strength and durability the vertex of the V-shaped depth profile of the at least one elongated recess has an angle of approx. 90°.

In another beneficial example according to the disclosure, the at least one recess is formed as a dent.

In yet another example of such solder junction wherein the resulting solder interface exhibits a further improved mechanical strength and durability two recesses are each applied on opposite sides of the solder connection. Additionally, a further recess may be applied between both two recesses, such that the further recess is covered by the solder junction. A solder junction being composed of two or even three recesses provides a sufficient large solder reservoir and the resulting solder interface between the bond clip and the lead frame has a higher mechanical strength and improved durability.

The semiconductor package according to the disclosure further comprises a molding resin case encapsulating the semiconductor package, thus creating a semiconductor package assembly.

According to the disclosure, the method of manufacturing the semiconductor package according to the disclosure comprises steps of:
i) preparing a lead metallic frame having a first frame surface side and a second frame surface side opposite from the first surface side;
ii) providing at least one recess in at least a first section of the first frame surface side of the lead metallic frame;
iii) applying solder material in the at least one recess and on at least a further section of the first frame surface side of the lead metallic frame;
iv) connecting at least one semiconductor die structure having a first die surface side and a second die surface side opposite from the first die surface side, with its second die surface side with the solder material applied on the further section of the first frame surface side of the lead metallic frame;
v) applying solder material on the first die surface side of the at least one semiconductor die structure;
vi) connecting at least a first bond clip with the solder material applied on the first die surface side of the at least one semiconductor die structure;
vii) connecting at least a further bond clip with the solder material applied in the at least one recess on the at least first section of the first frame surface side of the lead metallic frame;
viii) molding the lead metallic frame, the at least one semiconductor structure, the first bond clip and the further bond clip into a package with clip leads of both the at least first and at least further bond clip exposed and extended to the external part of the molded package;
ix) trimming and forming the exposed clip leads of both the at least first and at least further bond clip;
x) singulating the semiconductor package from the lead metallic frame.

The resulting solder junction between the bond clip and the lead metallic frame in the singulated semiconductor package assembly thus obtained with the method, has next to an improved electrical connectivity also an improved mechanical connection. The at least one recess thus formed in the lead frame surface creates a reservoir for the solder material. The resulting connecting interface of solder junction between the bond clip and the lead frame exhibits a high mechanical strength and durability.

In a particular example of the method according to the disclosure, step ii) comprises the step of applying at least two recesses in the at least first section of the first frame surface side of the lead metallic frame, and more in particular step ii) comprises the step of applying a third recess between both two recesses in the at least first section of the first frame surface side of the lead metallic frame. A solder junction being composed of two or even three recesses provides sufficient large solder reservoir and the resulting solder interface between the bond clip and the lead metallic frame has a higher mechanical strength and improved durability.

In preferred examples, step ii) comprises the step of applying the at least one recess as an elongated recess extending in a direction parallel or transverse to a longitudinal orientation of the lead metallic frame. The choice of orientation is in part dependent on the desired connecting interface between the bond clip and the lead frame and any constraints as to the dimensions of the lead frame compared to the semiconductor die structure.

### BRIEF DESCRIPTION OF THE DRAWINGS

The disclosure will now be discussed with reference to the drawings, which show in:
Figure 1 the various steps of an example of the method according to the disclosure;
Figures 2a-2c several details of a semiconductor package (assembly) according to the disclosure;
Figures 3a-3c further details and examples of a semiconductor package (assembly) according to the disclosure;
Figures 4a-4b another details of examples of a semiconductor package (assembly) according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

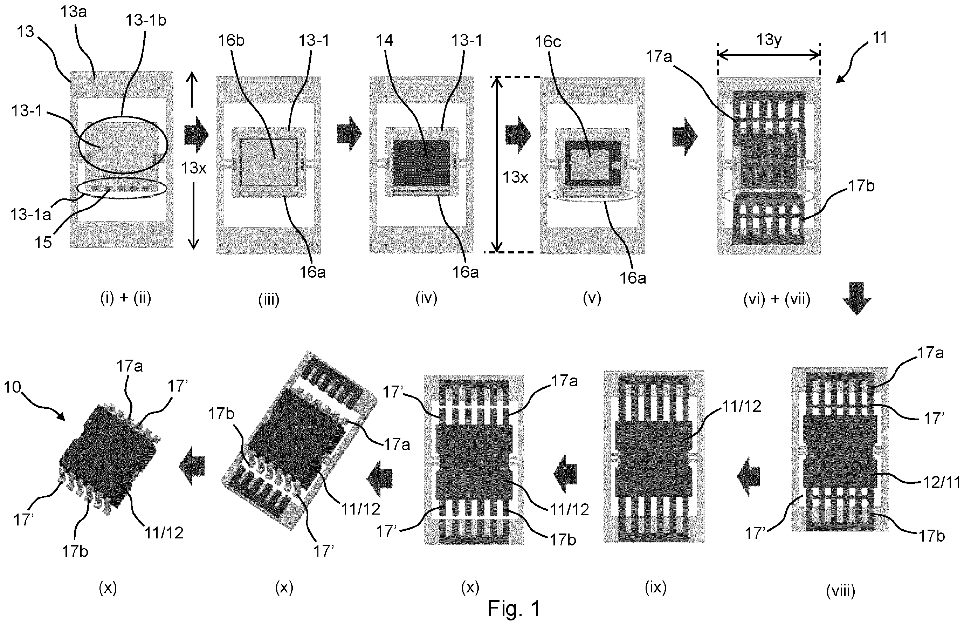

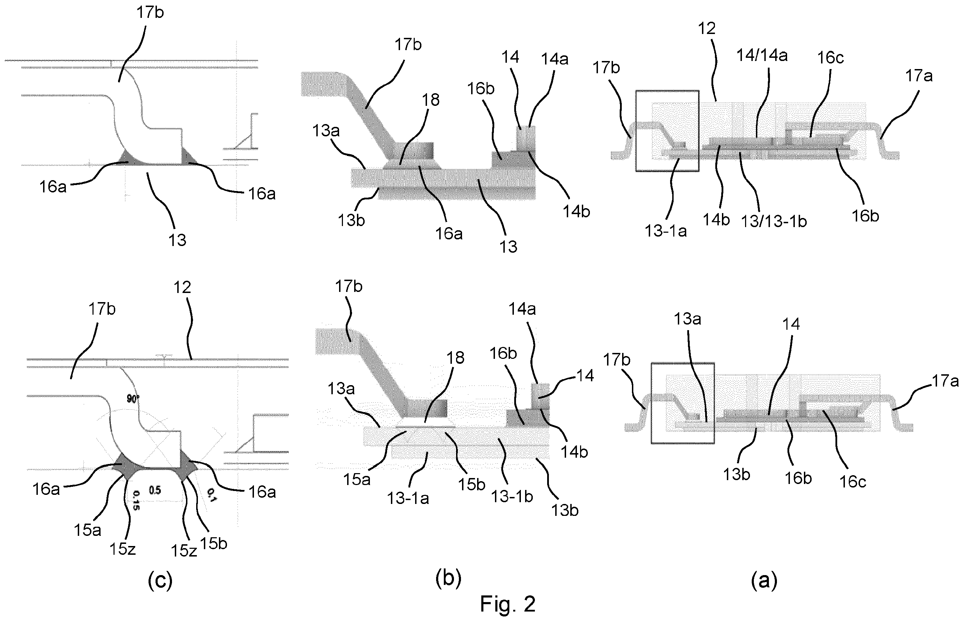

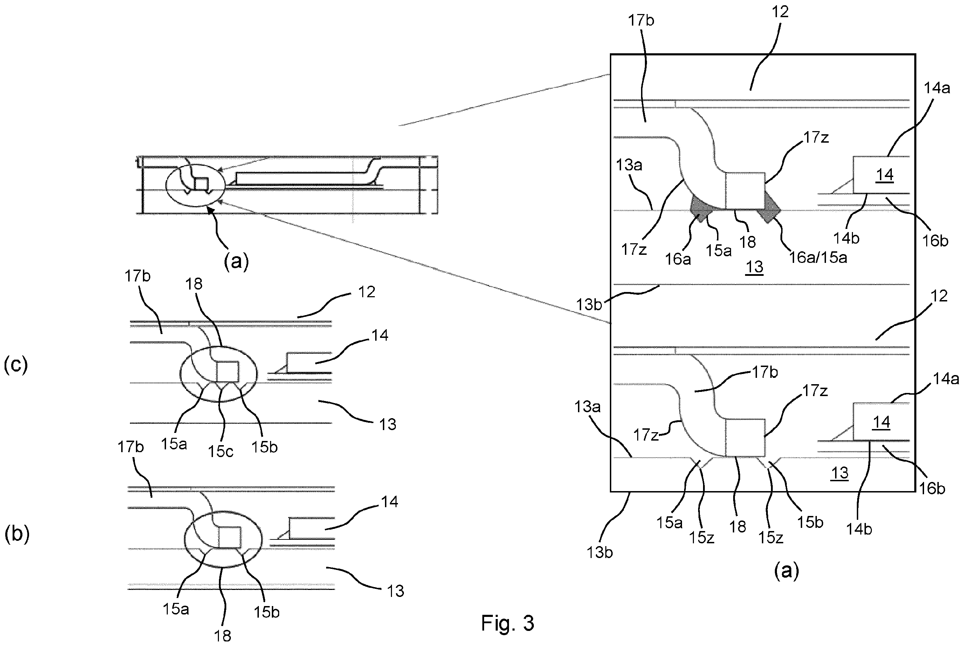

Figure 1 depicts the various steps (i)-(x) of an example of the method according to the disclosure. In a first step (i) a lead metallic frame 13 is prepared for having a semiconductor die mounted thereon. The lead metallic frame 13 can be chosen from any electrically conductive metal material but preferably copper is used for the lead frame. Also with reference to e.g. the details of Figure 2 and Figure 3a, the lead metallic frame 13 has a planar structure with a first frame surface side 13a (facing the viewer of the page of Figure 1) and a second frame surface side 13b opposite from the first surface side 13a. The lead frame 13 may comprise a die pad 13-1 which die pad surface 13a is composed of a first section 13-1a of the first frame side 13a and a second, further section 13-1b of the first frame side 13a.

Reference numeral 13x denotes a longitudinal orientation of the lead frame/die pad 13/13-1. For a clear understanding in this application, the longitudinal orientation 13x is considered being longer than the transverse orientation 13y.

Step ii) of the method according to the disclosure pertains to providing at least one recess 15 in at least the first section 13-1a of the first frame surface side 13a of the lead frame 13 / die pad 13-1. Preferably multiple recesses are applied in the first frame surface side 13a of the lead frame 13 / die pad 13-1. The recesses 15 can be applied by convention known techniques, such as stamping, laser cutting, etching or any similar process.

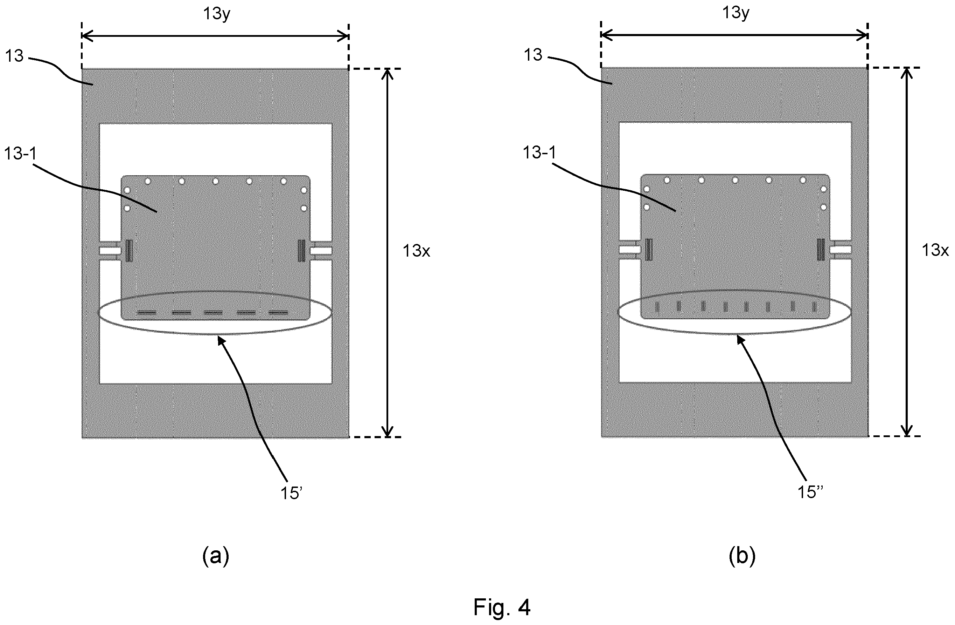

As shown in more detail in Figures 4a and 4b, in particular example, the step ii) may comprise the step of applying the at least one recess 15 as an elongated recess extending in a direction transverse (see Figure 4a: recess 15') or parallel (see Figure 4b: recess 15") to the longitudinal orientation 13x of the lead frame 13. As discussed in more detailed further, the choice of orientation is in part dependent on the desired connecting interface between the bond clip and the lead frame and any constraints as to the dimensions of the lead frame compared to the semiconductor die structure.

Returning to Figure 1, step iii) of the method according to the disclosure pertains to applying solder material 16a in the recess(es) 15, as well as applying solder material 16b and on at least a further section 13-1b of the first frame surface side 13a of the lead frame 13 / die pad 13-1. The solder material 16b being applied on the at least further section 13-1b of the first frame surface side 13a assists step iv) of the method, wherein at least one semiconductor die structure 14 is connected with said solder material 16b applied on the further section 13-1b of the first frame surface side 13 of the lead frame 13 / die pad 13-1.

As shown in detail in Figure 2 and Figure 3a, the semiconductor die structure 14 has a first die surface side 14a and a second die surface side 14b opposite from the first die surface side 14a. When executing step iv) of the method according to the disclosure, the semiconductor die structure 14 is connected with its second die surface side 14b with the solder material 16b.

In Figure 1, in step v) solder material 16c is applied on the first die surface side 14a of the at least one semiconductor die structure 14 and subsequently step vi) pertains to (electrically and mechanically) connecting at least a first bond clip 17a with the solder material 16c as applied on the first die surface side 14a of the at least one semiconductor die structure 14. One or more first bond clips 17a may for example function to provide an electrical connection with the gate and source of the semiconductor die structure 14, if the latter is configured for example as a MOSFET. The bond clips used can be made from copper in order to improve electric connectivity.

Next in step vii) at least a further bond clip 17b is electrically and mechanically connected with the solder material 16a applied in the at least one recess 15 on the at least first section 13-1a of the first frame surface side 13a of the lead frame 13 / die pad 13-1. When this step vii) is finalized a semiconductor package 11 is obtained consisting of a lead frame 13, a semiconductor die structure 14 and several bond clips 17a-17b.

In order to finalize the semiconductor package assembly, the semiconductor package 11 is encapsulated using a plastic resin 12 in step viii) of the method according to the disclosure, by molding the lead frame 13 in particular the die pad 13-1, the at least one semiconductor structure 14, the first bond clip 17a and the further bond clip 17b into a package 10 with clip leads 17' of both the at least first and at least further bond clip 17a-17b exposed, thus extending outside the molded package 11/12. Herewith the fragile solder junctions between the bond clips 17a-17b and the semiconductor die structure 14 and the lead frame 13 are immobilized and protected. Herewith a proper handling and processing of the semiconductor package assembly in semiconductor applications is possible.

Final step ix) and x) of the method pertain to trimming and forming the exposed clip leads 17' of both the at least first and at least further bond clip 17a-17b (step ix) and singulating the semiconductor package 11/12 from the lead frame 13 thus obtaining a singulated, encapsulated semiconductor package assembly 10 (step x).

The resulting solder junction 18 between the further bond clip 17b and the lead frame 13 / die pad 13-1 in the singulated semiconductor package assembly 10 thus obtained with the method has next to an improved electrical connectivity also an improved mechanical connection. The at least one recess 15 formed during step ii) above in the first lead frame surface 13a creates a reservoir for the solder material 16a, see the details in Figures 2 and 3. The resulting connecting interface of solder junction 18 between the bond clip 17b and the lead frame 13 exhibits a high mechanical strength and durability.

In addition, as detailed in Figure 2 and Figures 3b several recesses 15 may be applied when performing step ii) of the method next or adject to each on opposite sides of the solder connection 18 to be formed. For instance, Figure 3b shows two recesses 15a-15b being applied on opposite sides of the solder connection 18 to be formed.

Furthermore, the detail of Figure 3c depicts a further example of the method according to the disclosure, wherein during step ii) a third recess 15c is applied between both two recesses 15a-15b in the at least first section 13-1a of the first frame surface side 13a of the lead frame 13 / die pad 13-1. A solder junction 18 being composed of two recesses 15a-15b or even three recesses 15a-16b-15c provides a sufficient large solder reservoir and the resulting solder interface between the further bond clip 17b and the lead frame 13 / die pad 13-1 has a higher mechanical strength and improved durability.

In conformity with the method according to the disclosure as detailed above, the semiconductor package thus obtained is at least composed of a lead metallic frame 13, with a semiconductor die structure 14 being mounted on a die pad 13-1 of the lead frame 13. At least a first bond clip 17a is electrically and mechanically connected with the semiconductor die structure 14 by means of a solder connection 16b whereas at least a further bond clip 17b is electrically and mechanically connected with the die pad 13-1 of the lead frame 13 by means of a solder junction 18 composed of solder material 16a.

According to the disclosure, the die pad 13-1 is provided with at least one recess 15 near the connection or solder junction 18 with the at least further bond clip 17b and the at least one recess 15 accommodates solder 16a for the solder junction 18.

Accordingly, the solder material volume near the bond clip edges 17z of the copper bond clip 17b and/or in between the copper bond clip 17b and the lead frame surface 13a is significantly increased. Next to an improved electrical connectivity also an improved mechanical connection between the bond clip 17b and the lead frame 13 / die pad 13-1 is achieved. The connecting interface or solder junction 18 between the further bond clip 17b and the lead frame 13 has an improved and stronger and more durable mechanical strength and is less susceptible to solder degradation due to repetitive mechanical loads.

In beneficial examples and as outlined in Figure 4a and 4b, the at least one recess 15 has an elongated configuration, wherein the at least one elongated recess 15 is shaped as a trench or a groove. The example of a grooved recess is detailed in Figure 2c with the at least one elongated recess 15 having a V-shaped depth profile. Such V-shaped depth profile creates an effective reservoir for solder material 16a. Accordingly, an increased mechanical strength along the connecting interface of the solder junction 18 between the bond clip 17b and the lead frame 13 is achieved, once the solder junction 18 has been established.

In an preferred example wherein the resulting solder interface 18 has a high mechanical strength and durability the vertex 15z of the V-shaped depth profile of the at least one elongated recess 15 (15a-15b-15c) has an angle of approx. 90°. See Figure 2c.

In another beneficial example according to the disclosure, the at least one recess 15 is formed as a dent.

In yet another example as detailed in Figures 2c and 3b, a solder junction 18 with a solder interface exhibiting improved mechanical strength and durability two recesses 15a and 15b are each applied on opposite sides of the solder connection 18. Additionally, a further recess 15c may be applied between both two recesses 15a-15b, such that the further recess 15c is covered by the solder junction 18. A solder junction 18 being composed of two or even three recesses 15a-15b-15c provides a sufficient large solder reservoir for the solder material 16a and the resulting solder interface/junction 18 between the bond clip 17b and the lead frame 13 / die pad 13-1 has a higher mechanical strength and improved durability.

The semiconductor package according to the disclosure further comprises a molding resin case 12 encapsulating the semiconductor package 11, thus creating a semiconductor package assembly 10.

Particular implementations of such elongated recesses extend either in a direction transverse to the longitudinal orientation 13x of the lead frame 13 / die pad 13-1 or in a direction parallel to that longitudinal orientation 13x, as depicted in Figure 4a (recess 15') and 4b (recess 15"). For a clear understanding in this application, the longitudinal orientation 13x is considered being longer than the transverse orientation 13y of the lead frame 13 / die pad 13-1. The choice of orientation is in part dependent on the desired connecting interface between the bond clip 17b and the lead frame 13 and any constraints as to the dimensions of the lead frame compared to the semiconductor die structure.

### LIST OF REFERENCE NUMERALS USED

- 10: encapsulated semiconductor package assembly
- 11: semiconductor package
- 12: moulding resin case
- 13: lead frame
- 13a: first frame side of lead frame
- 13b: second frame side of lead frame
- 13-1: die pad
- 13-1a: first section of first frame side of lead frame / die pad
- 13-1b: second, further section of first frame side of lead frame / die pad
- 13x: longitudinal orientation of lead frame / die pad
- 13y: transverse orientation of lead frame / die pad
- 14: semiconductor die structure
- 14a: first die side of semiconductor die structure
- 14b: second die side of semiconductor die structure
- 15: recess
- 15'/15": different orientations of a recess
- 15a: first recess
- 15b: second recess
- 15c: third, intermediate recess
- 15z: vertex of recess
- 16a: solder material on first section
- 16b: solder material on second section
- 16c: solder material on first die side of semiconductor die structure
- 17a: first bond clip
- 17b: further bond clip
- 17z: bond clip edges near the solder junction
- 17': bond clip leads
- 18: solder junction between first bond clip and lead frame / die pad

## Claims

1. A semiconductor package at least comprising:
- a lead metallic frame;
- a semiconductor die structure being mounted on a die pad of the lead frame;
- at least a first bond clip connected with the semiconductor die structure;
- at least a further bond clip connected with the die pad of the lead frame by means of a solder junction; wherein
the die pad is provided with at least one recess near the connection with the at least further bond clip for accommodating solder for the solder junction.

2. The semiconductor package according to claim 1, wherein the at least one recess has an elongated configuration.

3. The semiconductor package according to claim 2, wherein the at least one elongated recess is shaped as a trench or a groove.

4. The semiconductor package according to claim 2 or 3, wherein the at least one elongated recess extends in a direction parallel to a longitudinal orientation of the die pad.

5. The semiconductor package according to claim 2 or 3, wherein the at least one elongated recess extends in a direction transverse to a longitudinal orientation of the die pad.

6. The semiconductor package according to any one or more of the claims 1-5, wherein the at least one elongated recess has a V-shaped depth profile.

7. The semiconductor package according to claim 6, wherein the vertex of the V-shaped depth profile of the at least one elongated recess has an angle of approx.. 90°.

8. The semiconductor package according to claim 1 or 2, wherein the at least one recess is formed as a dent.

9. The semiconductor package according to any one or more of the claims 1-8, wherein two recesses are each applied on opposite sides of the connection.

10. The semiconductor package according to claim 9, wherein a further recess is applied between both two recesses, such that the further recess is covered by the solder junction.

11. The semiconductor package according to any one or more of the claims 1-10, further comprising a molding resin case encapsulating the semiconductor package.

12. A method of manufacturing the semiconductor package according to anyone of claims 1-11, the method comprising steps of:
i) preparing a lead metallic frame having a first frame surface side and a second frame surface side opposite from the first surface side;
ii) providing at least one recess in at least a first section of the first frame surface side of the lead metallic frame;
iii) applying solder material in the at least one recess and on at least a further section of the first frame surface side of the lead metallic frame;
iv) connecting at least one semiconductor die structure having a first die surface side and a second die surface side opposite from the first die surface side, with its second die surface side with the solder material applied on the further section of the first frame surface side of the lead metallic frame;
v) applying solder material on the first die surface side of the at least one semiconductor die structure;
vi) connecting at least a first bond clip with the solder material applied on the first die surface side of the at least one semiconductor die structure;
vii) connecting at least a further bond clip with the solder material applied in the at least one recess on the at least first section of the first frame surface side of the lead metallic frame;
viii) molding the lead frame, the at least one semiconductor structure, the first bond clip and the further bond clip into a package with clip leads of both the at least first and at least further bond clip exposed;
ix) trimming and forming the exposed clip leads of both the at least first and at least further bond clip;
x) singulating the semiconductor package from the lead metallic frame.

13. The method according to claim 12, wherein step ii) comprises the step of applying at least two recesses in the at least first section of the first frame surface side of the lead frame.

14. The method according to claim 13, wherein step ii) comprises the step of applying a third recess between both two recesses in the at least first section of the first frame surface side of the lead frame.

15. The method according to any one or more of the claims 12-14, wherein step ii) comprises the step of applying the at least one recess as an elongated recess extending in a direction parallel or transverse to a longitudinal orientation of the lead frame.
